# EUROPEAN PATENT SPECIFICATION

(11) **EP 2 072 483 B1**
(45) Date of publication and mention of the grant of the patent: **07.08.2013**
(21) Application number: 08106003.0
(22) Date of filing: 17.12.2008
(51) Int. Cl.: C04B 37/02

(54) **Ceramic-copper foil bonding method**
Keramik-Kupferfolienbindungsverfahren
Procédé de liaison de feuille de cuivre-céramique

(30) Priority: 18.12.2007 TW 96148408
(43) Date of publication of application: 24.06.2009
(73) Proprietor: Tong Hsing Electronic Industries, Ltd., Taipei City (TW)
(72) Inventor: Chiang, Wen-Chung, Banciao City, Taipei County 22072 (TW); Wu, Keng-Chung, Banciao City, Taipei County 22072 (TW); Wu, Jun-Jae, Banciao City, Taipei County 22072 (TW)
(74) Representative: Cohausz & Florack

(56) References cited:
- DE-A1- 10 221 876
- JP-A- 6 090 083
- US-A- 6 066 219
- US-A1- 2007 261 778

## Description

This application claims priority of Taiwanese application no. 096148408, filed on December 18, 2007.

This invention relates to a method of bonding a copper foil to a ceramic substrate according to claim 1, more particularly to a bonding method including oxidation of a copper foil to form a copper oxide layer that is subsequently bonded to a ceramic substrate through heat treatment.

Direct bonding copper (DBC) or direct copper bonding (DCB) is a conventional method of bonding a copper foil to a ceramic substrate. In the conventional method, a copper foil is oxidized such that a surface of the copper foil is oxidized to a copper oxide layer. The copper foil is disposed on a surface of a ceramic substrate such that the copper oxide layer is in contact with the surface of the ceramic substrate. The copper foil and the ceramic substrate are heated together to a temperature that is lower than 1083°C (the melting point of copper) and higher than 1063°C (the eutectic temperature of the copper-copper oxide eutectic). Therefore, the copper foil is bonded to the surface of the ceramic substrate.

Conventionally, the surface of the copper foil is oxidized to the copper oxide layer by pre-heating the copper foil before the copper foil and the ceramic substrate are heated together. However, when the copper foil is pre-heated, two copper oxide layers are formed on two opposite surfaces of the copper foil.

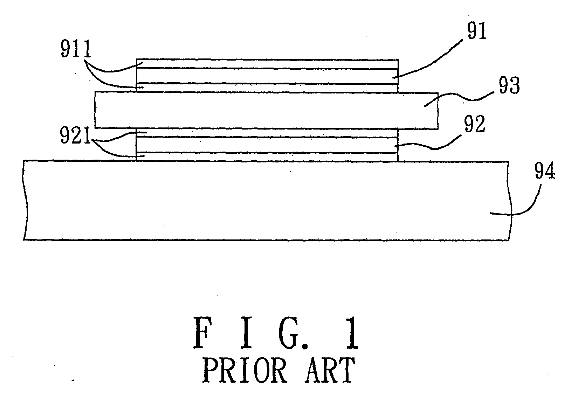

Referring to FIG. 1, a first copper foil 91 has two copper oxide layers 911 and is disposed on a first surface of a ceramic substrate 93 such that one of the copper oxide layers 911 is in contact with the first surface of the ceramic substrate 93. A second copper foil 92 has two copper oxide layers 921 and is disposed between the ceramic substrate 93 and a saggar 94 that is made from a ceramic material and that is used for holding together the first copper foil 91, the ceramic substrate 93, and the second copper foil 92. The copper oxide layers 921 of the second copper foil 92 are respectively in contact with a second surface of the ceramic substrate 93 and a surface of the saggar 94. If the first copper foil 91, the ceramic substrate 93, and the second copper foil 92 are heated together with the saggar 94, the first and second copper foils 91,92 will be respectively bonded to the first and second surfaces of the ceramic substrate 93, and the second copper foil 92 will be undesirably bonded to the surface of the saggar 94. Therefore, if two sides of a ceramic substrate are to be bonded respectively to two copper foils, each of which has two opposite copper oxide layers, an undesired bond will be formed between one of the copper foils and a saggar.

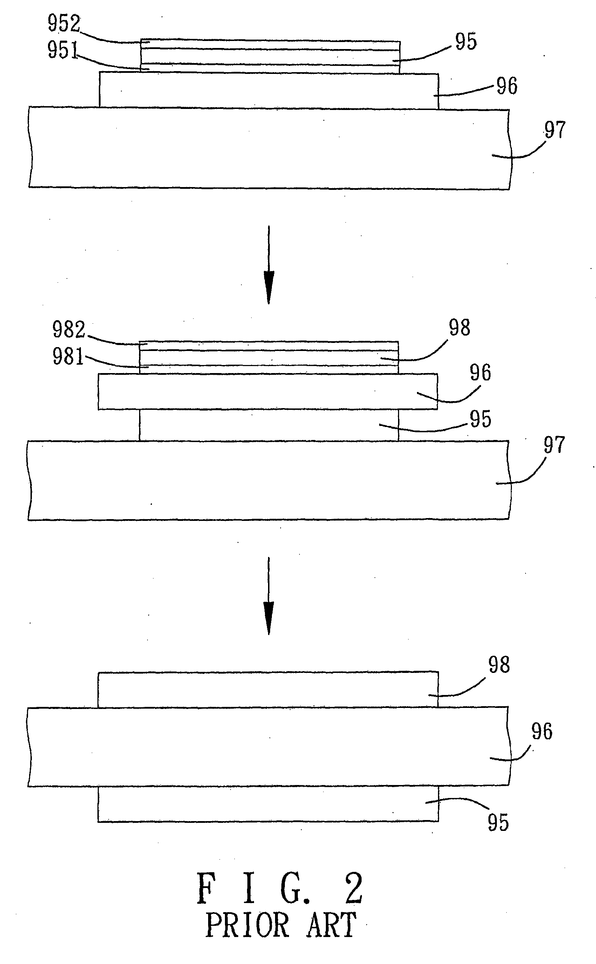

In order to avoid the aforesaid problem, the prior art suggests a method of bonding two copper foils to two surfaces of a ceramic substrate as illustrated in FIG. 2. A first copper foil 95 that has a first copper oxide layer 951 and a second copper oxide layer 952 is disposed on a first surface of a ceramic substrate 96 that is disposed on a surface of a saggar 97. The first copper oxide layer 951 of the first copper foil 95 is in contact with the first surface of the ceramic substrate 96. When the first copper foil 95 and the ceramic substrate 96 are heated together, the first copper foil 95 is bonded to the first surface of the ceramic substrate 96. The second copper oxide layer 952 of the first copper foil 95 is subsequently reduced to copper. Afterward, the first copper foil 95 and the ceramic substrate 96 are inverted such that the saggar 97 is in contact with the surface of the first copper foil 95 where the second copper oxide layer has been reduced to copper. Thereafter, a second copper foil 98 that has a first copper oxide layer 981 and a second copper oxide layer 982 is disposed on a second surface of the ceramic substrate 96. The first copper oxide layer 981 of the second copper foil 98 is in contact with the second surface of the ceramic substrate 96. When the second copper foil 98, the ceramic substrate 96, and the first copper foil 95 are heated together, the second copper foil 98 is bonded to the second surface of the ceramic substrate 96. The second copper oxide layer 982 of the second copper foil 98 is subsequently reduced to copper. As such, none of the first and second copper foils 95,98 is bonded to the surface of the saggar 97. However, the conventional method requires several heat treatment steps and is thus complicated and energy consuming.

Therefore, the object of the present invention is to provide a ceramic-copper foil bonding method that can eliminate the aforesaid drawbacks of the prior art and that employs wet-oxidation to oxidize a copper foil.

According to one aspect of this invention, a ceramic-copper foil bonding method comprises wet-oxidizing a first copper foil such that a first surface of the first copper foil is oxidized to a copper oxide layer, contacting the copper oxide layer with a first surface of a ceramic substrate, and bonding the copper oxide layer of the first copper foil to the first surface of the ceramic substrate by heat treatment.

According to another aspect of this invention, a ceramic-copper foil bonding method comprises: providing first and second copper foils, each of which has a first surface and a second surface opposite to the first surface; wet-oxidizing the first and second copper foils such that the first surface of each of the first and second copper foils is oxidized to a copper oxide layer and the second surface of each of the first and second copper foils is not oxidized; contacting the copper oxide layers of the first and second copper foils with opposite first and second surfaces of a ceramic substrate, respectively; and heating together the first copper foil, the second copper foil, and the ceramic substrate, thereby bonding the same together.

Other features and advantages of the present invention will become apparent in the following detailed description of the preferred embodiments of this invention, with reference to the accompanying drawings, in which:
FIG. 1 is a schematic view to illustrate a problem that might occur if a ceramic substrate is bonded to two copper foils which are oxidized through a method employed in the art;
FIG. 2 is a schematic flow chart to illustrate a conventional method of bonding two copper foils to a ceramic substrate;
FIG. 3 is a schematic flow chart to illustrate a ceramic-copper foil bonding method conducted in Example 1 of this invention; and
FIG. 4 is a schematic flow chart to illustrate another ceramic-copper foil bonding method conducted in Example 2 of this invention.

According to the present invention, a ceramic-copper foil bonding method includes wet-oxidizing a first copper foil such that a first surface of the first copper foil is oxidized to a copper oxide layer, contacting the copper oxide layer with a first surface of a ceramic substrate, and bonding the copper oxide layer of the first copper foil to the first surface of the ceramic substrate by heat treatment.

The ceramic-copper foil bonding method further includes providing a protective layer on a second surface of the first copper foil, which is opposite to the first surface of the first copper foil, before wet-oxidizing the first copper foil such that the second surface of the first copper foil is not oxidized during wet-oxidizing the first copper foil. The protective layer is a tape attached to the second surface of the first copper foil. The tape may be made from a material selected from the group consisting of polyvinyl chloride, polyethylene terephthalate, and polyimide.

In an embodiment, the method further includes roughening the first copper foil before wet-oxidizing the first copper foil. Preferably, the first copper foil is roughened in a roughening solution including hydrogen peroxide, sulfuric acid, and a stabilizer. The stabilizer is one selected from the group consisting of ethylamine and acetamide. The roughening solution includes sulfuric acid in a concentration that ranges from 100 to 250 grams per liter of the roughening solution, hydrogen peroxide in a concentration that ranges from 20 to 40 grams per liter of the roughening solution, and the stabilizer in a concentration that ranges from 0.5 to 15 grams per liter of the roughening solution. The roughening solution is kept at a temperature that ranges from 25°C to 60°C. The first copper foil is roughened in the roughening solution for 1 to 5 minutes.

The first copper foil is wet-oxidized in an oxidizing solution including an oxidizing agent selected from the group consisting of potassium persulfate, sodium phosphate, and sodium chlorite. The oxidizing solution includes the oxidizing agent in a concentration that ranges from 2 to 60 grams per liter of the oxidizing solution. In an embodiment,theoxidizingsolutionfurther includes sodium hydroxide. The oxidizing solution is kept at a temperature that ranges from 25°C to 80°C. The first copper foil is wet-oxidized in the oxidizing solution for 10 seconds to 10 minutes.

In another embodiment, the method further includes forming an oxygen-isolation layer on a surface of the copper oxide layer of the first copper foil to prevent further oxidation before contacting the copper oxide layer with the first surface of the ceramic substrate. To this end, the copper oxide layer of the first copper foil is disposed in an anti-oxidizing solution including an antioxidant for forming the oxygen-isolation layer. The antioxidant is made from a material selected from the group consisting of benzotriazole, triazole, imidazole, and tetrazole. The anti-oxidizing solution is kept at a temperature that ranges from 25°C to 60°C. The copper oxide layer of the first copper foil is disposed in the anti-oxidizing solution for 10 seconds to 5 minutes.

In still another embodiment, the method further includes: wet-oxidizing a second copper foil such that a first surface of the second copper foil is oxidized to a copper oxide layer, and a second surface of the second copper foil, which is opposite to the first surface of the second copper foil, is not oxidized; contacting the copper oxide layer of the second copper foil with a second surface of the ceramic substrate, which is opposite to the first surface of the ceramic substrate, before bonding the copper oxide layer of the first copper foil to the first surface of the ceramic substrate; and bonding the copper oxide layer of the second copper foil to the second surface of the ceramic substrate simultaneously with the bonding of the copper oxide layer of the first copper foil to the first surface of the ceramic substrate by heat treatment.

### Example 1

This example is not part of the invention.

### Roughening

30 g hydrogen peroxide, 150 g sulfuric acid, and 10. g ethylamine were added to 1 L de-ionized water so as to form a roughening solution. Subsequently, the roughening solution was heated to about 50°C.

A first copper foil was cleaned. A tape was attached to one surface of the first copper foil as a protective layer, while another surface of the first copper foil was kept exposed. When the first copper foil was soaked in the roughening solution for approximately 3 minutes, the exposed surface opposite to the tape was corroded and formed into a rough layer. The chemical reaction for roughening the first copper foil is as follows:

Cu+H₂O₂+H₂SO₄→CuSO₄+2H₂O

The first copper foil was removed from the roughening solution and subsequently rinsed with de-ionized water. Wet-oxidizing

40 g sodium chlorite and 30 g sodium hydroxide were added to 1 L de-ionized water so as to form an oxidizing solution. The oxidizing solution was heated to about 77°C. When the first copper foil was soaked in the oxidizing solution for approximately 5 minutes, the rough layer of the first copper foil was oxidized to a copper oxide layer. The chemical reaction for wet-oxidizing the first copper foil is as follows:

2Cu+NaClO₂+2H₂O→2Cu(OH)₂+NaCl 2Cu(OH)₂→2CuO+2H₂O

The first copper foil having the copper oxide layer was removed from the oxidizing solution, rinsed with de-ionized water, and dried in sequence. When the first copper foil was dry, the tape was detached from the first copper foil. The first copper foil thus had one surface formed with the copper oxide layer, and another surface of the first copper foil to which the tape was attached was not oxidized during wet-oxidizing the first copper foil.

### Bonding

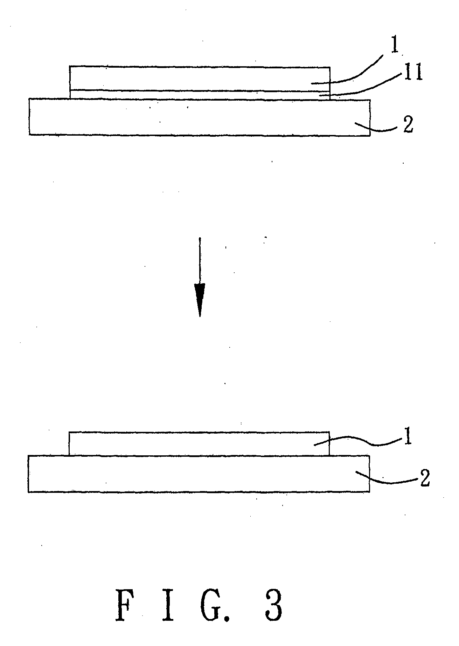

Referring to FIG. 3, the first copper foil 1 was disposed on a first surface of a ceramic substrate 2 made from aluminum oxide such that the copper oxide layer 11 of the first copper foil 1 was in contact with the first surface of the ceramic substrate 2. The first copper foil 1 and the ceramic substrate 2 were heated to about 1070°C for 20 minutes in an atmosphere having a 20 ppm oxygen level. Thus, the first copper foil 1 was bonded to the first surface of the ceramic substrate 2.

If the bonding step is not to be conducted immediately after the wet-oxidizing step, an oxygen-isolation layer may be formed on a surface of the copper oxide layer of the first copper foil. Therefore, the copper oxide layer of the first copper foil can be isolated from oxygen by virtue of the oxygen-isolation layer so as to prevent the first copper foil from further oxidation that may result in thickening of the copper oxide layer and hence in reducing the bonding strength. To form the oxygen-isolation layer, the first copper foil having the copper oxide layer was soaked in a 10 g/L benzotriazole solution. After about 2 minutes, the first copper foil was removed from the benzotriazole solution and formed with the oxygen-isolation layer.

### Example 2

### Roughening

30 g hydrogen peroxide, 150 g sulfuric acid, and 1 g acetamide were added to 1 L de-ionized water so as to form a roughening solution. Subsequently, the roughening solution was heated to about 50 °C.

A first copper foil and a second copper foil were cleaned. Each of the first and second copper foils had opposite first and second surfaces. A tape was attached to the second surface of the first copper foil as a protective layer. The first surface of the first copper foil was exposed to the roughening solution. Another tape was attached to the second surface of the second copper foil as a protective layer. The first surface of the second copper foil was exposed to the roughening solution.

The first and second copper foils were soaked in the roughening solution for approximately 5 minutes. Each of the second surfaces of the first and second copper foils was corroded so as to form a rough layer. The chemical reaction for roughening the first and second copper foils is as follows:

Cu+H₂O₂+H₂SO₄→CuSO₄+2H₂O

The first and second copper foils were removed from the roughening solution and subsequently rinsed with de-ionized water.

### Wet-oxidizing

10 g potassium persulfate and 50 g sodium hydroxide were added to 1 L de-ionized water in order to form an oxidizing solution. The oxidizing solution was heated to about 60 °C. The first and second copper foils were soaked in the oxidizing solution for approximately 7 minutes. Each of the rough layers of the first and second copper foils was oxidized to a copper oxide layer. The chemical reaction for wet-oxidizing the first and second copper foils is as follows:

K₂S₂O₈+2NaOH→K₂SO₄+Na₂SO₄+H₂O+ [O] Cu+2NaOH+ [O]→Na₂CuO₂+H₂O Na₂CuO₂+H₂O→CuO+2NaOH

The first and second copper foils were removed from the oxidizing solution, rinsed with de-ionized water, and dried in sequence. The tapes were respectively detached from the first and second copper foils when the first and second copper foils were dry. The first and second copper foils had the first surfaces thereof oxidized, and the second surfaces thereof were not oxidized.

### Bonding

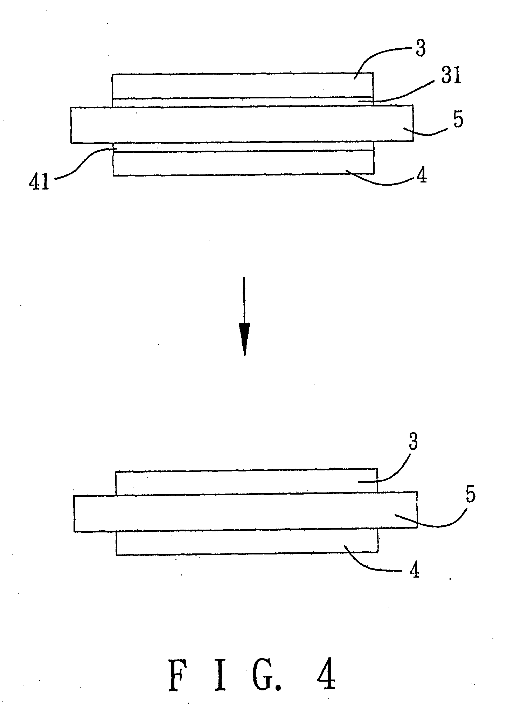

Referring to FIG. 4, the first copper foil 3 having the copper oxide layer 31, and the second copper foil 4 having the copper oxide layer 41 were disposed in contact with a ceramic substrate 5 made from aluminum nitride. The copper oxide layer 31 of the first copper foil 3 was in contact with a first surface of the ceramic substrate 5. The copper oxide layer 41 of the second copper foil 4 was in contact with a second surface of the ceramic substrate 5. The first copper foil 3, the ceramic substrate 5, and the second copper foil 4 were heated to about 1072°C for 15 minutes in an atmosphere having a 20 ppm oxygen level. Therefore, the first and second copper foils 3,4 were respectively bonded to the first and second surfaces of the ceramic substrate 5.

According to the present invention, two copper foils can be bonded to a ceramic substrate through a single heat treatment step, thereby reducing energy necessary for bonding two copper foils to a ceramic substrate compared to the conventional method. The method is simple and can be performed at a relatively low cost.

## Claims

1. A ceramic-copper foil bonding method comprising:
wet-oxidizing a first copper foil (1,3,4) such that a first surface of the first copper foil (1,3,4) is oxidized to a copper oxide layer (11,31,41);
contacting the copper oxide layer (11,31,41) with a first surface of a ceramic substrate (2,5); and
bonding the copper oxide layer (11,31,41) of the first copper foil (1,3,4) to the first surface of the ceramic substrate (2,5) by heat treatment;
wherein the ceramic-copper foil bonding method is **characterized by** the step of attaching a tape as a protecting layer to a second surface of the first copper foil (1,3,4), which is opposite to the first surface of the first copper foil (1,3,4),
before wet-oxidizing the first copper foil (1,3,4) such that the second surface of the first copper foil (1,3,4) is not oxidized during wet-oxidizing the first copper foil (1,3,4).

2. The method of claim 1, **characterized in that** the first copper foil (1,3,4) is wet-oxidized in an oxidizing solution including an oxidizing agent selected from the group consisting of potassium persulfate, sodium phosphate, and sodium chlorite.

3. The method of claim 2, further **characterized in that** the oxidizing solution includes the oxidizing agent in a concentration that ranges from 2 to 60 grams per liter of the oxidizing solution.

4. The method of claim 1, further **characterized by** roughening the first surface of the first copper foil (1,3,4) before wet-oxidizing the first copper foil (1,3,4).

5. The method of claim 4, **characterized in that** the first copper foil (1,3,4) is roughened in a roughening solution including hydrogen peroxide, sulfuric acid, and a stabilizer.

6. The method of claim 5, further **characterized in that** the roughening solution includes sulfuric acid in a concentration that ranges from 100 to 250 grams per liter of the roughening solution.

7. The method of claim 6, further **characterized in that** the roughening solution includes hydrogen peroxide in a concentration that ranges from 20 to 40 grams per liter of the roughening solution.

8. The method of claim 7, further **characterized in that** the roughening solution includes the stabilizer in a concentration that ranges from 0.5 to 15 grams per liter of the roughening solution.

9. The method of claim 8, further **characterized in that** the stabilizer is one selected from the group consisting of ethylamine and acetamide.

10. The method of claim 1, further **characterized by** forming an oxygen-isolation layer on a surface of the copper oxide layer (11,31,41) of the first copper foil (1,3,4) before contacting the copper oxide layer (11,31,41) with the first surface of the ceramic substrate (2,5).

11. The method of claim 10, **characterized in that** the copper oxide layer (11,31,41) of the first copper foil (1,3,4) is disposed in an anti-oxidizing solution including an antioxidant for forming the oxygen-isolation layer.

12. The method of claim 11, further **characterized in that** the antioxidant is made from a material selected from the group consisting of benzotriazole, triazole, imidazole, and tetrazole.

13. The method of claim 1, further **characterized by**:
wet-oxidizing a second copper foil (4) such that a first surface of the second copper foil (4) is oxidized to a copper oxide layer (41), and a second surface of the second copper foil (4), which is opposite to the first surface of the second copper foil (4), is not oxidized;
contacting the copper oxide layer (41) of the second copper foil (4) with a second surface of the ceramic substrate (5), which is opposite to the first surface of the ceramic substrate (5), before bonding the copper oxide layer (31) of the first copper foil (3) to the first surface of the ceramic substrate (5); and
bonding the copper oxide layer (41) of the second copper foil (4) to the second surface of the ceramic substrate (5) simultaneously with the bonding of the copper oxide layer (31) of the first copper foil (3) to the first surface of the ceramic substrate (5) by heat treatment.

## Patentansprüche

1. Keramik-Kupferfolienbindungsverfahren enthaltend:
das Nassoxidieren einer ersten Kupferfolie (1,3,4), derart, dass eine erste Oberfläche der ersten Kupferfolie (1,3,4) zu einer Kupferoxidschicht (11,31,41) oxidiert wird;
das Kontaktieren der Kupferoxidschicht (11,31,41) mit einer ersten Oberfläche eines Keramiksubstrats (2,5); und
das Verbinden der Kupferoxidschicht (11,31,41) der ersten Kupferfolie (1,3,4) mit der ersten Oberfläche des Keramiksubstrats (2,5) durch Wärmebehandlung;
wobei das Keramik-Kupferfolienbindungsverfahren **gekennzeichnet ist durch** den Schritt des Befestigens eines Bands als Schutzschicht an einer zweiten Oberfläche der ersten Kupferfolie (1,3,4), die sich der ersten Oberfläche der ersten Kupferfolie (1,3,4) gegenüber befindet, vor dem Nassoxidieren der ersten Kupferfolie (1,3,4), derart, dass die zweite Oberfläche der ersten Kupferfolie (1,3,4) während des Nassoxidierens der ersten Kupferfolie (1,3,4) nicht oxidiert wird,

2. Verfahren nach Anspruch 1, **dadurch gekennzeichnet, dass** die erste Kupferfolie (1,3,4) in einer Oxidationslösung, die ein Oxidationsmittel enthält ausgewählt aus der Gruppe bestehend aus Kaliumpersulfat, Natriumphosphat und Natriumchlorit, nassoxidiert wird.

3. Verfahren nach Anspruch 2, des Weiteren **dadurch gekennzeichnet, dass** die Oxidationslösung das Oxidationsmittel in einer Konzentration enthält, die im Bereich von 2 bis 60 Gramm pro Liter Oxidationslösung liegt.

4. Verfahren nach Anspruch 1, des Weiteren **gekennzeichnet durch** Aufrauen der ersten Oberfläche der ersten Kupferfolie (1,3,4) vor dem Nassoxidieren der ersten Kupferfolie (1,3,4).

5. Verfahren nach Anspruch 4, **dadurch gekennzeichnet, dass** die erste Kupferfolie (1,3,4) in einer Aufraulösung aufgeraut wird, die Wasserstoffperoxid, Schwefelsäure und einen Stabilisator enthält.

6. Verfahren nach Anspruch 5, des Weiteren **dadurch gekennzeichnet, dass** die Aufraulösung Schwefelsäure in einer Konzentration enthält, die im Bereich von 100 bis 250 Gramm pro Liter der Aufraulösung liegt.

7. Verfahren nach Anspruch 6, des Weiteren **dadurch gekennzeichnet, dass** die Aufraulösung Wasserstoffperoxid in einer Konzentration enthält, die im Bereich von 20 bis 40 Gramm pro Liter der Aufraulösung liegt.

8. Verfahren nach Anspruch 7, des Weiteren **dadurch gekennzeichnet, dass** die Aufraulösung den Stabilisator in einer Konzentration enthält, die im Bereich von 0,5 bis 15 Gramm pro Liter der Aufraulösung liegt.

9. Verfahren nach Anspruch 8, des Weiteren **dadurch gekennzeichnet, dass** der Stabilisator einer ist ausgewählt aus der Gruppe bestehend aus Ethylamin und Acetamid.

10. Verfahren nach Anspruch 1, des Weiteren **gekennzeichnet durch** Bilden einer Sauerstoffisolierschicht auf einer Oberfläche der Kupferoxidschicht (11,31,41) der ersten Kupferfolie (1,3,4) vor Kontaktieren der Kupferoxidschicht (11,31,41) mit der ersten Oberfläche des Keramiksubstrats (2,5).

11. Verfahren nach Anspruch 10, **dadurch gekennzeichnet, dass** die Kupferoxidschicht (11,31,41) der ersten Kupferfolie (1,3,4) sich in einer Antioxidationslösung befindet, die ein Antioxidationsmittel zum Bilden der Sauerstoffisolierschicht enthält.

12. Verfahren nach Anspruch 11, des Weiteren **dadurch gekennzeichnet, dass** das Antioxidationsmittel aus einem Material hergestellt ist ausgewählt aus der Gruppe bestehend aus Benzotriazol, Triazol, Imidazol und Tetrazol.

13. Verfahren nach Anspruch 1, des Weiteren **gekennzeichnet durch**:
das Nassoxidieren einer zweiten Kupferfolie (4), derart, dass eine erste Oberfläche der zweiten Kupferfolie (4) zu einer Kupferoxidschicht (41) oxidiert wird und eine zweite Oberfläche der zweiten Kupferfolie (4), die sich der ersten Oberfläche der zweiten Kupferfolie (4) gegenüber befindet, nicht oxidiert wird;
das Kontaktieren der Kupferoxidschicht (41) der zweiten Kupferfolie (4) mit einer zweiten Oberfläche des Keramiksubstrats (5), das sich der ersten Oberfläche des Keramiksubstrats (5) gegenüber befindet, vor dem Verbinden der Kupferoxidschicht (31) der ersten Kupferfolie (3) mit der ersten Oberfläche des Keramiksubstrats (5); und
das Verbinden der Kupferoxidschicht (41) der zweiten Kupferfolie (4) mit der zweiten Oberfläche des Keramiksubstrats (5) gleichzeitig mit dem Verbinden der Kupferoxidschicht (31) der ersten Kupferfolie (3) mit der ersten Oberfläche des Keramiksubstrats (5) **durch** Wärmebehandlung.

## Revendications

1. Procédé de soudage d'une feuille de cuivre-céramique consistant à :
oxyder à l'état humide d'une première feuille de cuivre (1, 3, 4) de sorte qu'une première surface de la première feuille de cuivre (1, 3, 4) soit oxydée en une couche d'oxyde de cuivre (11, 31, 41) ;
mettre en contact la couche d'oxyde de cuivre (11, 31, 41) avec une première surface d'un substrat en céramique (2, 5) ; et
souder la couche d'oxyde de cuivre (11, 31, 41) de la première feuille de cuivre (1, 3, 4) sur la première surface du substrat de céramique (2, 5) par traitement thermique ;
le procédé de soudage d'une feuille de cuivre-céramique étant **caractérisé par** l'étape d'attachement d'un ruban comme forme de couche protectrice sur une seconde surface de la première feuille de cuivre (1, 3, 4), qui est opposée à la première surface de la première feuille de cuivre (1, 3, 4), avant l'oxydation à l'état humide de la première feuille de cuivre (1, 3, 4), de sorte que la seconde surface de la première feuille de cuivre (1, 3, 4) ne soit pas oxydée pendant l'oxydation à l'état humide de la première feuille de cuivre (1, 3, 4).

2. Procédé selon la revendication 1, **caractérisé en ce que** la première feuille de cuivre (1, 3, 4) est oxydée à l'état humide dans une solution d'oxydation incluant un agent d'oxydation sélectionné dans le groupe constitué par le persulfate de potassium, le phosphate de sodium et le chlorite de sodium.

3. Procédé selon la revendication 2, **caractérisé en outre en ce que** la solution d'oxydation comprend l'agent d'oxydation en une concentration qui est comprise dans la plage allant de 2 à 60 gramme par litre de la solution d'oxydation.

4. Procédé selon la revendication 1, **caractérisé en outre par** le dépolissage de la première surface de la première feuille de cuivre (1, 3, 4) avant l'oxydation à l'état humide de la première feuille de cuivre (1, 3, 4).

5. Procédé selon la revendication 4, **caractérisé en ce que** la première feuille de cuivre (1, 3, 4) est dépolie dans une solution de dépolissage incluant du peroxyde d'hydrogène, de l'acide sulfurique et un stabilisateur.

6. Procédé selon la revendication 5, **caractérisé en outre en ce que** la solution de dépolissage comprend de l'acide sulfurique à une concentration comprise dans la plage allant de 100 à 250 gramme par litre de la solution de dépolissage.

7. Procédé selon la revendication 6, **caractérisé en outre en ce que** la solution de dépolissage comprend du peroxyde d'hydrogène à une concentration comprise dans la plage allant de 20 à 40 gramme par litre de la solution de dépolissage.

8. Procédé selon la revendication 7, **caractérisé en outre en ce que** la solution de dépolissage comprend le stabilisateur à une concentration comprise dans la plage allant de 0,5 à 15 gramme par litre de la solution de dépolissage.

9. Procédé selon la revendication 8, **caractérisé en outre en ce que** le stabilisateur est sélectionné dans le groupe constitué par l'éthylamine et l'acétamide.

10. Procédé selon la revendication 1, **caractérisé en outre par** la formation d'une couche d'isolement vis-à-vis de l'oxygène sur une surface de la couche d'oxyde de cuivre (11, 31, 41) de la première feuille de cuivre (1, 3, 4) avant la mise en contact de la couche d'oxyde de cuivre (11, 31, 41) avec la première surface du substrat de céramique (2, 5).

11. Procédé selon la revendication 10, **caractérisé en ce que** la couche d'oxyde de cuivre (11, 31, 41) de la première feuille de cuivre (1, 3, 4) est placée dans une solution anti-oxydante incluant un antioxydant pour la formation de la couche d'isolement vis-à-vis de l'oxygène.

12. Procédé selon la revendication 11, **caractérisé en outre en ce que** l'antioxydant est préparé à partir d'une substance sélectionnée dans le groupe constitué par le benzotriazole, le triazole, l'imidazole et le tétrazole.

13. Procédé selon la revendication 1, **caractérisé en outre par** :
l'oxydation à l'état humide d'une seconde feuille de cuivre (4) de sorte qu'une première surface de la seconde feuille de cuivre (4) soit oxydée en une couche d'oxyde de cuivre (41), et une seconde surface de la seconde feuille de cuivre (4), qui est opposée à la première surface de la seconde feuille de cuivre (4) ne soit pas oxydée ;
la mise en contact de la couche d'oxyde de cuivre (41) de la seconde feuille de cuivre (4) avec une seconde surface du substrat de céramique (5), qui est opposée à la première surface du substrat de céramique (5), avant le soudage de la couche d'oxyde de cuivre (31) de la première feuille de cuivre (3) sur la première surface du substrat de céramique (5) ; et
le soudage de la couche d'oxyde de cuivre (41) de la seconde feuille de cuivre (4) sur la seconde surface du substrat de céramique (5) de manière simultanée avec le soudage de la couche d'oxyde de cuivre (31) de la première feuille de cuivre (3) sur la première surface du substrat de céramique (5) par traitement thermique.
